# EUROPEAN PATENT APPLICATION

(11) **EP 3 264 478 A1**
(43) Date of publication of application: **03.01.2018**
(21) Application number: 16177352.8
(22) Date of filing: 30.06.2016
(51) Int. Cl.: H01L 35/30, F01N 5/02

(54) **THERMOELECTRIC HEAT RECOVERY SYSTEM, EXHAUST SYSTEM AND METHOD FOR CONVERTING WASTE HEAT INTO ENERGY**

(71) Applicant: European Thermodynamics Limited, Kibworth, Leicester LE8 0RX (GB)
(72) Inventor: FRANCESCONI, Guido, Leicester, LE8 0RX (GB); CHIWANGA, States, Cambridge, CB3 0GT (GB); TULEY, Richard, Leicester, Leicestershire LE8 0RX (GB)
(74) Representative: Braddon, Nicholas

(57) **Abstract**

This invention provides a thermoelectric heat recovery system comprising: an inlet for receiving a fluid; an outlet; a heat exchanger located between, and in fluid communication with, the inlet and the outlet, the heat exchanger comprising a plurality of heat exchange conduits, wherein, in use, the fluid flows in a first direction through a given heat exchange conduit and in a second direction opposite to the first direction through the or each heat exchange conduit adjacent the given heat exchange conduit; and one or more thermoelectric generators, wherein the or each thermoelectric generator has a heat exchanger contact surface which is in thermal contact with at least a portion of at least two adjacent heat exchange conduits, such that, in use, the heat exchanger contact surface forms the hot side or cold side of the thermoelectric generator.

## Description

The present invention relates to thermoelectric heat recovery systems. In particular, the invention provides an improved thermoelectric heat recovery system for converting waste heat into electricity.

In recent years, there has been a global drive to develop environmentally friendly solutions which reduce waste energy. As such, there is an on-going demand for a more efficient thermoelectric heat recovery system.

A thermoelectric generator is an energy generating device which can be used wherever there is a temperature difference. For example, a thermoelectric generator can operate using the temperature difference between a hot pipe or surface and the ambient air temperature. A thermoelectric generator comprises one or more elements comprising one or more thermoelectric materials which are semiconductors having low thermal conductivity but high electrical conductivity. When a temperature gradient is established across an element comprising a thermoelectric material, electrons flow across the material, thereby generating an electrical current.

Thermoelectric generators may be used to convert waste heat emitted from vehicle exhaust systems and industrial flues or furnaces into electricity. Typically, a thermoelectric heat recovery system comprises multiple thermoelectric generators. The electrical energy generated by such a system may be stored (e.g. in a battery) or it may be used to at least partially power one or more devices. For example, in an exhaust heat recovery system, the electrical energy output may be used to at least partially power a motor (e.g. in a hybrid vehicle), charge one or more batteries, or supply power to one or more electrical components in the vehicle.

It is known for a thermoelectric heat recovery system to comprise a bypass circuit. The bypass circuit may provide an alternative path for the fluid from which the waste heat is extracted (e.g. heat exchange fluid, such as steam) that is not in thermal communication with the thermoelectric generator(s). Generally, the bypass circuit is activated when the temperature of the fluid and/or of one or more thermoelectric generators exceeds a critical threshold. An example of a known bypass control circuit is disclosed in US8554407.

The efficiency of most known thermoelectric heat recovery systems is at least partially limited by the existence of a gradient in the temperature of the hot side of the thermoelectric generator in the direction of flow of the heat exchange fluid. This gradient is caused by heat loss from the fluid as it travels through the heat recovery system. Consequently, there will be a smaller temperature difference between the hot side and the cold side of a given thermoelectric generator located at or near a downstream end of the heat recovery system than between the hot side and the cold side of a given thermoelectric generator located at or near an upstream end of the heat recovery system. This gradient in the temperature of the hot side or the cold side of each of the thermoelectric generators can cause thermal expansion problems and reduce the output of the thermoelectric generators.

One known solution to this problem is to use different thermoelectric materials in thermoelectric generators at different positions along the heat recovery system. For example, the heat recovery system may be divided into high, medium and low temperature zones with thermoelectric generators comprising different thermoelectric materials for each zone. An example of such a thermoelectric heat recovery system is disclosed in US20110067742. It is also known to regulate flow rate throughout the thermoelectric heat recovery system to control the amount of heat loss from the fluid.

Another known solution is to attempt to reduce the gradient in the temperature of the hot side or the cold side of the thermoelectric generators by optimising the distribution of heat exchange fins in the pipe(s) or conduit(s) through which the heat exchange fluid flows. The density of the fin distribution can be increased towards the outlet of the conduit to increase the proportion of heat transferred from the fluid to the hot side of the thermoelectric generator, thereby at least partially compensating for the lower average temperature of the fluid towards the outlet. An example of such a system is disclosed in US20130340801.

According to a first aspect of the invention, there is provided a thermoelectric heat recovery system comprising: an inlet for receiving a fluid; an outlet; a heat exchanger located between, and in fluid communication with, the inlet and the outlet, the heat exchanger comprising a plurality of heat exchange conduits, wherein, in use, the fluid flows in a first direction through a given heat exchange conduit and in a second direction opposite to the first direction through the or each heat exchange conduit adjacent the given heat exchange conduit; and one or more thermoelectric generators, wherein the or each thermoelectric generator has a heat exchanger contact surface which is in thermal contact with at least a portion of at least two adjacent heat exchange conduits, such that, in use, the heat exchanger contact surface forms the hot side or cold side of the thermoelectric generator.

In some embodiments, the thermoelectric heat recovery system may comprise a plurality of thermoelectric generators. Optionally, the thermoelectric generator(s) may be in thermal contact with all of the heat exchange conduits along substantially the entire length of the heat exchange conduits.

If the fluid flowing through the heat exchange conduits is a hot fluid relative to the surrounding ambient air (or other fluid) then the heat exchanger contact surface(s) in thermal contact with at least a portion of at least two adjacent heat exchange conduits forms, in use, the hot side of the thermoelectric generator(s).

Conversely, if the fluid flowing through the heat exchange conduits is a cold fluid relative to the surrounding ambient air (or other fluid) then the heat exchanger contact surface(s) in thermal contact with at least a portion of at least two adjacent heat exchange conduits forms, in use, the cold side of the thermoelectric generator(s).

The heat recovery system of the present invention reduces the difference in the temperature of the heat exchanger contact surfaces of the thermoelectric generators. In other words, the present invention reduces the difference between the temperature of the hot side (or alternatively cold side) of each of the thermoelectric generators.

For a heat recovery system using a hot fluid the temperature of the fluid will decrease due to thermal losses as the fluid flows along each heat exchange conduit from the inlet towards the outlet. The reverse is true for a heat recovery system using a cold fluid. Thus, as each thermoelectric generator has a heat exchanger contact surface which is in thermal contact with at least a portion of at least two adjacent heat exchange conduits, and as the fluid flows in opposite directions in adjacent conduits, these thermal losses (or gains) are averaged out. This results in each heat exchanger contact surface having substantially the same average temperature (or surface temperature). Hence, in use, the hot side (or cold side) of each thermoelectric generator may be at a similar or even substantially the same temperature.

Advantageously, reducing the gradient in the temperature of the hot side (or cold side) of the thermoelectric generators may also reduce any thermal expansion of the heat exchanger.

In some embodiments, the gradient in the temperature of the hot side (or cold side) of the thermoelectric generators may be minimised and/or the gradient may be substantially neutralised.

The present invention may be advantageous compared with heat recovery systems which optimise the distribution of heat exchange fins in the heat exchange conduit, e.g. US20130340801. For example, in US20130340801 the heat exchange fin distribution is optimised for a certain flow rate and temperature of the fluid. In practice, the flow rate and temperature of the fluid through the heat exchanger is not constant, thus the gradient in the temperature of the hot side of the thermoelectric generators would not be cancelled unless the flow rate and temperature of the fluid were strictly controlled. This is not required in the present invention, as a change in the flow rate or inlet temperature of the fluid will affect all of the thermoelectric generators equally.

In addition, heat exchangers used with a hot fluid typically have a very high thermal conductivity (i.e. rate of heat transfer to the hot side of the thermoelectric generators), even without the use of fins. It can therefore be very difficult for heat exchange fins to effectively adjust the amount of heat transferred from the fluid to the thermoelectric generators. The use of heat exchange fins, particularly if they are very densely packed, can also increase thermal stresses in the heat exchanger.

Optionally, the length of each heat exchange conduit may be substantially the same.

In some embodiments, some or all of the plurality of heat exchange conduits may be substantially parallel to each other along at least a portion of their lengths. Additionally or alternatively, at least two adjacent heat exchange conduits may be wound helically around each other along at least a portion of their lengths. Optionally, each pair of adjacent heat exchange conduits may comprise at least one common wall. The at least one common wall may have a high thermal conductivity.

In some embodiments, each heat exchange conduit may comprise a first end and a second end, wherein, in use, fluid may flow from the first end of a heat exchange conduit to the second end of the heat exchange conduit. The heat exchange conduits may be arranged such that the first end of a given heat exchange conduit is adjacent to the second end of the or each adjacent heat exchange conduit.

The first end of each heat exchange conduit may be in fluid communication with the inlet. The second end of each heat exchange conduit may be in fluid communication with the outlet.

Optionally, the heat exchanger may comprise a plurality of first heat exchange conduits and a plurality of second heat exchange conduits, the direction of fluid flow, in use, through the first heat exchange conduits being opposite that through the second heat exchange conduits. Each first heat exchange conduit may be positioned adjacent to at least one second heat exchange conduit. The first end of each first heat exchange conduit may be adjacent to the second end of a second heat exchange conduit.

In some embodiments, at least one given first heat exchange conduit may be in fluid communication with one of the second heat exchange conduits such that the second heat exchange conduit is located downstream of the given first heat exchange conduit . Each first heat exchange conduit may be in fluid communication with a second heat exchange conduit, such that the first and second heat exchange conduits are connected in pairs. The first end of each first heat exchange conduit may be in fluid communication with the inlet. Additionally or alternatively, the second end of each second heat exchange conduit may be in fluid communication with the outlet. For example, in use, fluid may flow from the inlet through a given first heat exchange conduit, then through a given second heat exchange conduit, then to the outlet.

Each first heat exchange conduit may be in fluid communication with an adjacent second heat exchange conduit. For example, in use, fluid may flow through a first heat exchange conduit in a first direction then through the adjacent second heat exchange conduit in a second direction.

A plurality of connecting pipes may connect the heat exchanger in fluid communication with the inlet and/or the outlet. For example, the plurality of connecting pipes may connect the first end of each heat exchange conduit to the inlet and/or the second end of each heat exchange conduit to the outlet.

Optionally, a plurality of connecting pipes may connect the second end of each first heat exchange conduit to the first end of each second heat exchange conduit.

In an embodiment, the connecting pipes extending from the inlet to the heat exchanger may be thermally insulating (i.e. poor thermal conductors) and/or the plurality of connecting pipes may be substantially surrounded by thermal insulation. This may reduce heat loss from the fluid (or heat gain in the case of a cold fluid) before the fluid enters the heat exchanger. Such heat loss (or gain) would reduce the temperature difference between the hot and cold sides of the thermoelectric generator(s), lowering the output of the generator(s). Optionally, each of the connecting pipes may be thermally insulated.

The plurality of connecting pipes may not be identical (i.e. the plurality of connecting pipes may not all be the same shape, length, size or made of the same material(s)). The plurality of connecting pipes may comprise rigid pipes and/or flexible hoses. For example, the plurality of connecting pipes may have a cylindrical cross section, and/or a rectangular cross-section.

Optionally, the heat exchange conduits may be made from or comprise one or more of copper, silver, gold, aluminium, iron or one or more other materials, e.g. metals or alloys, which have a high thermal conductivity.

The thermoelectric generator(s) may be directly and/or indirectly coupled to the heat exchange conduits. For example, the thermoelectric generators may be adhered to at least a portion of at least two adjacent heat exchange conduits by a thermally conductive adhesive.

In some embodiments, a graphite based interface material may be provided between the heat exchanger contact surface of the thermoelectric generator(s) and the heat exchange conduits. Graphite has a particularly high in-plane thermal conductivity, which may help further neutralize any gradient or difference in the temperature of the hot side (or the cold side) of the thermoelectric generators.

Additionally of alternatively, the thermoelectric generators may be soldered to at least a portion of at least two adjacent heat exchange conduits.

In some embodiments, some or all of the thermoelectric generators may comprise a thermally conductive housing.

Optionally, the heat recovery system may comprise a diffuser connected to the inlet (e.g. an inlet diffuser). The diffuser may comprise a plurality of apertures, wherein each aperture may be in fluid communication with at least one heat exchange conduit.

For example, each aperture of the inlet diffuser may receive one of a plurality of connecting pipes. Each of the connecting pipes extending from the inlet diffuser may be connected to the first end of a heat exchange conduit.

Optionally, the first end of each heat exchange conduit may be connected to the inlet diffuser, either directly or via a connecting pipe. In other embodiments, only the plurality of first heat exchange conduits may be in communication with the inlet diffuser.

The inlet diffuser may be thermally insulating (i.e. a poor thermal conductor). Additionally or alternatively, the diffuser may be substantially surrounded by thermal insulation. In use, this may reduce heat dissipation from the fluid (or heat gain in the case of a cold fluid) before the fluid enters the heat exchanger.

Additionally or alternatively, the heat exchanger may comprise a diffuser connected to the outlet (e.g. an outlet diffuser). The outlet diffuser may comprise a plurality of apertures, wherein each aperture may be in fluid communication with at least one heat exchange conduit.

For example, each aperture of the outlet diffuser may receive one of a plurality of connecting pipes. Each of the connecting pipes extending from the outlet diffuser may be connected to the second end of a heat exchange conduit. Optionally, the second end of each heat exchange conduit may be connected to the outlet diffuser, either directly or via a connecting pipe. In other embodiments, only the plurality of second heat exchange conduits may be in communication with the outlet diffuser.

Optionally, the heat recovery system may comprise a control valve operable to regulate the fluid flow rate in the heat exchange conduits. The control valve may be located in the inlet diffuser.

Optionally, the heat recovery system may comprise at least one bypass channel in fluid communication with the inlet. The at least one bypass channel may be configured to bypass one or more of the thermoelectric generators.

The heat recovery system may comprise a valve operable to activate the bypass channel(s). The valve may be located in the inlet. For example, when the valve is in an open position the heat exchange fluid may flow through one or more of the bypass channels. The bypass channel(s) may be activated (i.e. the valve may be opened) if the temperature and/or pressure of the fluid exceed(s) a predetermined threshold. This may prevent or minimise damage to the heat exchanger and/or the thermoelectric generators occurring, in use.

In known heat recovery systems the thermoelectric generators near the inlet commonly reach their maximum operating temperature (also known as critical temperature) before the thermoelectric generators located further from the inlet. This is due to the gradient in the temperature of the hot side of the generators. This often causes the bypass channel to be activated, in use.

In the present invention, all, or almost all, of the thermoelectric generators should reach critical temperature at approximately the same time due to the reduced (or minimised) gradient in the temperature of the hot side of the generators. Thus, the present invention may prevent 'premature' activation of the bypass channel, which may increase the length of time that the heat recovery system can be in operation, thereby potentially increasing the total output power of the thermoelectric generator(s).

In some embodiments, the bypass channel may be configured to bypass the entire heat exchanger. For example, when the bypass channel is activated fluid may not be able to flow through any of the heat exchange conduits. This may provide a 'perfect' bypass.

In some embodiments, the heat exchanger may comprise at least one heat exchange conduit which is not in thermal contact with any thermoelectric generators. The at least one heat exchange conduit may form a bypass channel.

The at least one heat exchange conduit forming the bypass channel may comprise a fluid flow path having a lower resistance than fluid flow paths through the heat exchange conduits which are in contact with a thermoelectric generator.

In some embodiments, at least one wall of the heat exchange conduit(s) forming the bypass channel may be thermally insulated. This may prevent or reduce any heat exchange between the bypass channel and the heat exchanger contact surface of the thermoelectric generator(s).

Optionally, the bypass channel may be separated from the heat exchange conduits which are in thermal contact with the thermoelectric generator(s) by an air gap.

Optionally, the heat exchange conduits which are in thermal contact with one or more thermoelectric generators may comprise a plurality of heat exchange fins. The thermoelectric generators may be in thermal contact with at least one of the fins. In an embodiment, each heat exchange conduit may comprise the same number and/or density of thermally conductive fins.

The bypass channel(s) may contain no thermally conductive fins.

In some embodiments, the heat recovery system may comprise two or more heat exchangers. Optionally, the heat exchangers may be arranged in layers (e.g. stacked one disposed at least partially above another or one surrounding another). In other embodiments, at least two of the heat exchangers may be disposed adjacent to each other.

The arrangement of the heat exchangers may improve, or maximise, the power output of the heat recovery system for the amount of space available.

The heat exchangers may be at least partially in thermal contact with each other. For example, some or all of the two or more heat exchangers may be in fluid communication with one another.

For example, the heat recovery system may comprise an upper heat exchanger and a lower heat exchanger. The upper and lower heat exchangers may each comprise a plurality of first heat exchange conduits and a plurality of second heat exchange conduits. Each first heat exchange conduit may be adjacent to at least one second heat exchange conduit. In use, fluid may flow in an opposite direction in the first conduits compared with the second conduits.

Each first heat exchange conduit in the upper heat exchanger may be in fluid communication with a second heat exchange conduit in the lower heat exchanger. Each second heat exchange conduit in the upper heat exchanger may be in fluid communication with a first heat exchange conduit in the lower heat exchanger. Each first heat exchange conduit may be in fluid communication with the inlet and each second heat exchange conduit may be in fluid communication with the outlet.

Optionally, more than one upper heat exchanger and/or more than one lower heat exchanger may be provided.

Optionally, each of the first heat exchange conduits of the two or more heat exchangers may be connected to the inlet diffuser by a connecting pipe. In some embodiments, more than one inlet diffuser may be provided.

Optionally, each of the second heat exchange conduits of the two or more heat exchangers may be connected to the outlet diffuser by a connecting pipe. In some embodiments, more than one outlet diffuser may be provided.

In some embodiments, more than one bypass channel may be provided. Each bypass channel may at least partially bypass one of the at least two heat exchangers.

According to a second aspect of the invention, there is provided an exhaust system comprising a heat recovery system of the first aspect of the invention, wherein the heat exchange fluid is an exhaust fluid and the heat exchanger contact surface(s) form the hot side of the thermoelectric generator(s).
Optionally, the exhaust system may be an automotive exhaust system and/or other internal combustion engine exhaust system.

The exhaust system may be a maritime or aerospace exhaust system. The exhaust system may be coupled to an industrial, commercial or residential building or structure.

According to a third aspect of the invention, there is provided a structure such as a building or a vehicle comprising or having coupled thereto at least one heat recovery system according to the first aspect of the invention.

For example, the vehicle may be a car, lorry, motorcycle, bus, train, aeroplane, helicopter and/or ship.
The heat recovery system may be configured to be used in one or more of the vehicle exhaust system and/or the engine coolant system (e.g. radiator).

The building may comprise for example: an industrial building such as a factory, an incinerator or a power plant; a commercial building; or a residential building.

According to a fourth aspect of the invention, there is provided a method of converting waste heat into electricity, the method comprising:
providing a heat recovery system according to the first aspect of the invention;
providing a waste hot fluid or a waste cold fluid;
channelling said waste hot fluid or waste cold fluid though the heat exchange conduits of the heat exchanger(s) of the heat recovery system; and
generating electricity using the thermoelectric generator(s) of the heat recovery system.

The generated electricity may be used to provide electrical power locally, e.g. within a structure such as a building or vehicle fitted with the heat recovery system of the invention, and/or the generated electricity may be transmitted to a remote location.

The method may comprise using a heat recovery system of any embodiment of the present invention.

The method may include bypassing one or more of the thermoelectric generators if the temperature and/or pressure of the fluid exceed(s) a predetermined threshold. Optionally, the method may include controlling the flow rate of the fluid in the heat exchange conduits using the valve.

Embodiments of the invention will now be described, by way of example only, with reference to the accompanying drawings, in which:
**Figure 1** shows a schematic illustration of the top view of a heat exchanger according to an embodiment of the invention;
**Figure 2** shows a schematic illustration of the heat exchanger of Figure 1 including a plurality of connecting pipes;
**Figure 3** shows an embodiment of a heat recovery system of the present invention (without thermoelectric generators);
**Figure 4** shows the system of Figure 3 including a plurality of thermoelectric generators;
**Figure 5** shows a further embodiment of a heat recovery system of the present invention (without thermoelectric generators); and
**Figure 6** shows a further embodiment of a heat recovery system of the present invention (without thermoelectric generators).

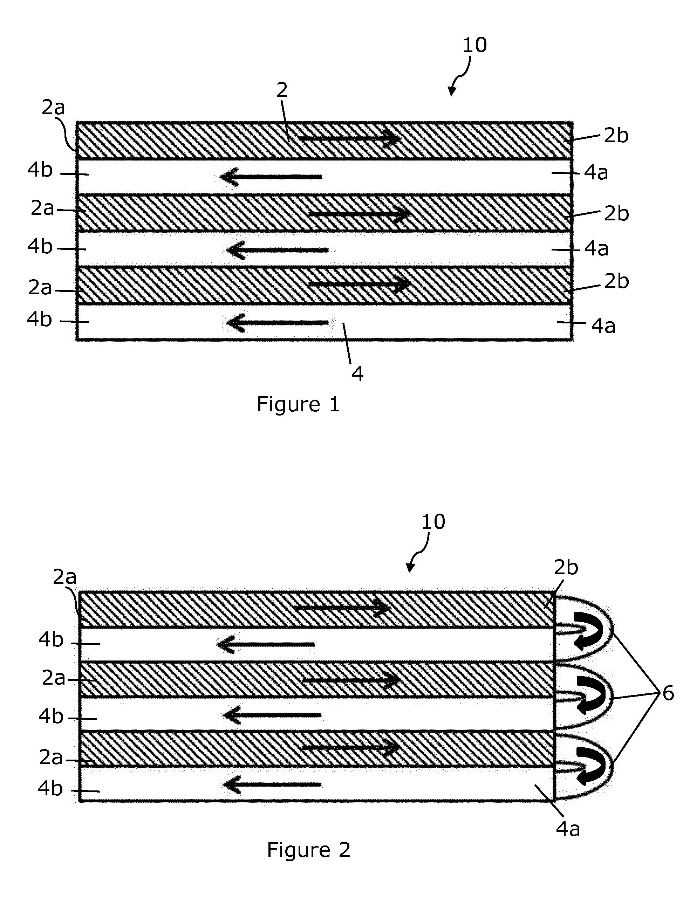

Figure 1 shows a heat exchanger 10 for use in a heat recovery system according to an embodiment of the invention. The heat exchanger 10 comprises six heat exchange conduits comprising three first heat exchange conduits 2 and three second heat exchange conduits 4. The three first heat exchange conduits 2 are alternate with the three second heat exchange conduits 4. The heat exchange conduits are arranged such that each first heat exchange conduit 2 is adjacent, and runs parallel, to at least one second heat exchange conduit 4. While six heat exchange conduits are shown in Figure 1, it will be appreciated that the heat exchanger 10 may comprise two or more heat exchange conduits, i.e. at least one first heat exchange conduit and at least one second heat exchange conduit.

Each first heat exchange conduit 2 comprises a first end 2a and a second end 2b. Each second heat exchange conduit 4 comprises a first end 4a and a second end 4b. The first ends 2a of the first heat exchange conduits 2 are adjacent the second ends 4b of the second heat exchange conduits 4, and vice versa. In use, fluid flows through the first and second heat exchange conduits from the first ends 2a, 4a to the second ends 2b, 4b. The fluid flow direction is indicated by the arrows in Figure 1. As illustrated, the direction of fluid flow alternates between each adjacent heat exchange conduit 2, 4 in the heat exchanger 10.

In some embodiments, the first ends 2a, 4a of the heat exchange conduits 2, 4 may be in fluid communication with an inlet, wherein the inlet receives, in use, a hot or cold fluid (e.g. an exhaust fluid or a coolant fluid).

The second ends 2b, 4b of the heat exchange conduits 2, 4 may be in fluid communication with an outlet. The outlet may provide an output path for the fluid after it has passed through the heat recovery system.

Alternatively, as shown in Figure 2, the second end 2b of each of the plurality of first heat exchange conduits 2 may be connected by a connecting pipe 6 to the first end 4a of one of the plurality of second heat exchange conduits 4, in this case a neighbouring second heat exchange conduit 4. Thus, in use, fluid may flow from an inlet through each of the first conduits 2, through each connecting pipe 6, through each of the second conduits 4 and towards an outlet. The fluid flow direction is indicated by the arrows in Figure 2.

A plurality of thermoelectric generators (not shown) are arranged to be in thermal contact with the heat exchanger 10, wherein a heat exchanger contact surface of each thermoelectric generator is in thermal contact with at least a portion of at least two adjacent heat exchange conduits (i.e. a portion of at least one first heat exchange conduit 2 and a portion of at least one second heat exchange conduit 4).

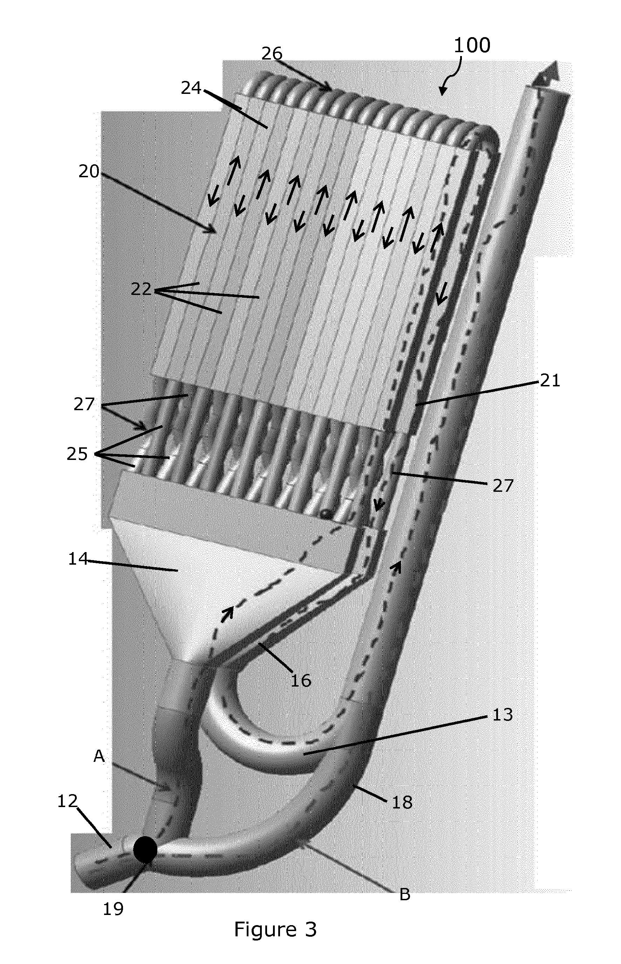

Figure 3 shows a heat recovery system 100 according to an embodiment of the invention. The thermoelectric generators are not shown to more clearly show the layout of the heat exchange conduits. The system comprises an inlet 12 for receiving a heat exchange fluid (e.g. a hot or cold fluid) and an outlet 13 for emitting the fluid.

An inlet diffuser 14 is connected to the inlet 12 and an outlet diffuser 16 is connected to the outlet 13.

In this example, the heat recovery system 100 comprises two heat exchangers, an upper heat exchanger 20 and a lower heat exchanger 21. Both heat exchangers 20, 21 may be equivalent or similar to heat exchanger 10 in Figure 1. In use, fluid flows in opposite directions in each adjacent heat exchange conduit 22, 24 of both the upper 20 and lower 21 heat exchangers. The heat exchange conduits 22, 24 may comprise a plurality of thermally conductive fins.

Each first heat exchange conduit 22 of the upper heat exchanger 20 is connected by a connecting pipe 26 to a second heat exchange conduit 24 of the lower heat exchanger 21. Similarly, each second heat exchange conduit 24 of the upper heat exchanger 20 is connected by a connecting pipe 26 to a first heat exchange conduit 22 of the lower heat exchanger 21.

In Figure 3, the heat exchange conduits are arranged such that each heat exchange conduit of the upper heat exchanger 20 is connected to the heat exchange conduit of the lower heat exchanger 21 that is located directly underneath it. Thus, the heat exchange conduits are connected in a series of adjacent pairs, each pair comprising one heat exchange conduit from the upper heat exchanger 20 and one heat exchange conduit from the lower heat exchanger 21. However, in other examples the heat exchange conduits may be connected differently.

The first heat exchange conduits 22 of the upper and lower heat exchangers 20, 21 are connected by connecting pipes 25 to the inlet diffuser 14. The second heat exchange conduits 24 of the upper and lower heat exchangers 20, 21 are connected by connecting pipes 27 to the outlet diffuser 16.

The connecting pipes 25 and 26 are thermally insulated. For example, the connecting pipes 25, 26 may be insulated copper pipes, or flexible hoses comprising thermally insulating walls. In order to reduce costs, connecting pipes 27 may not be thermally insulated, as it may not be important to prevent heat transfer from the fluid after it has passed through the heat exchangers 20, 21.

An example of a heat recovery fluid flow path through the heat exchangers 20, 21 is shown by path A.

A bypass channel 18 is in fluid communication with the inlet 12 and the outlet 13. In this example the bypass channel 18 bypasses the upper and lower heat exchangers 20, 21. The bypass fluid flow path is shown as path B in Figure 3.

A valve 19 located in the inlet 12 is operable to activate (i.e. allow fluid to flow through) the bypass channel 18. For example, when the valve 19 is in a closed position fluid may only flow from the inlet 12 to the inlet diffuser 14. When the valve 19 is in an open position fluid may only flow from the inlet 12 through the bypass channel 18. Thus, in Figure 3 the bypass channel 18 forms a 'perfect' bypass.

The bypass channel 18 may be activated if the temperature and/or pressure of the fluid and/or the temperature of the thermoelectric generators exceed(s) a predetermined threshold (e.g. a critical temperature and/or pressure). The bypass channel 18 may be activated remotely, automatically and/or manually.

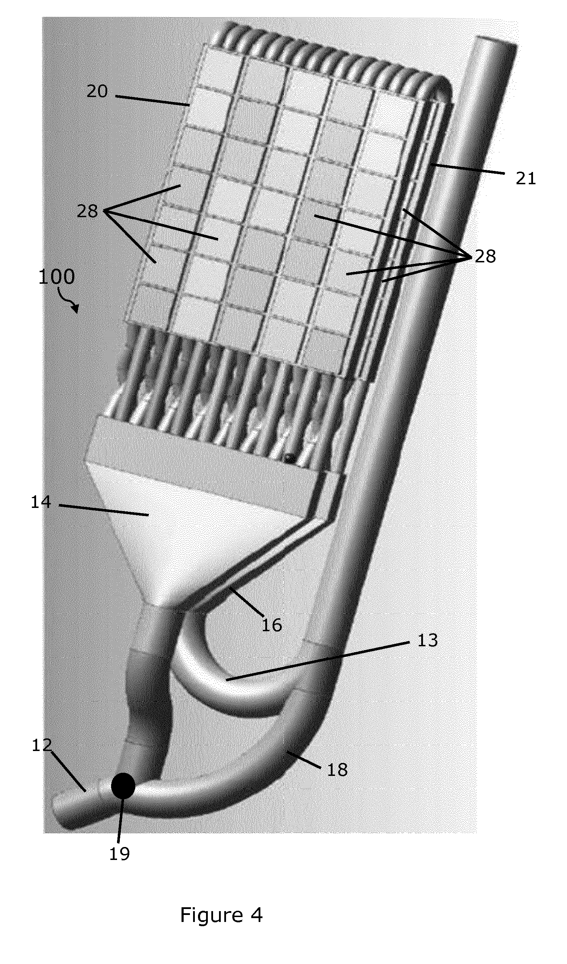

Figure 4 shows the heat recovery system 100 of Figure 3 including a plurality of thermoelectric generators 28. Each thermoelectric generator 28 has a heat exchanger contact surface which is in thermal contact with at least a portion of at least two adjacent heat exchange conduits 22, 24 of the upper or lower heat exchanger 20, 21.

Using two (or more) heat exchangers may increase the power output of the system, as thermoelectric generators may be provided on each level. By stacking the heat exchangers 20, 21 the spatial requirements of the heat recovery system may not be significantly increased.

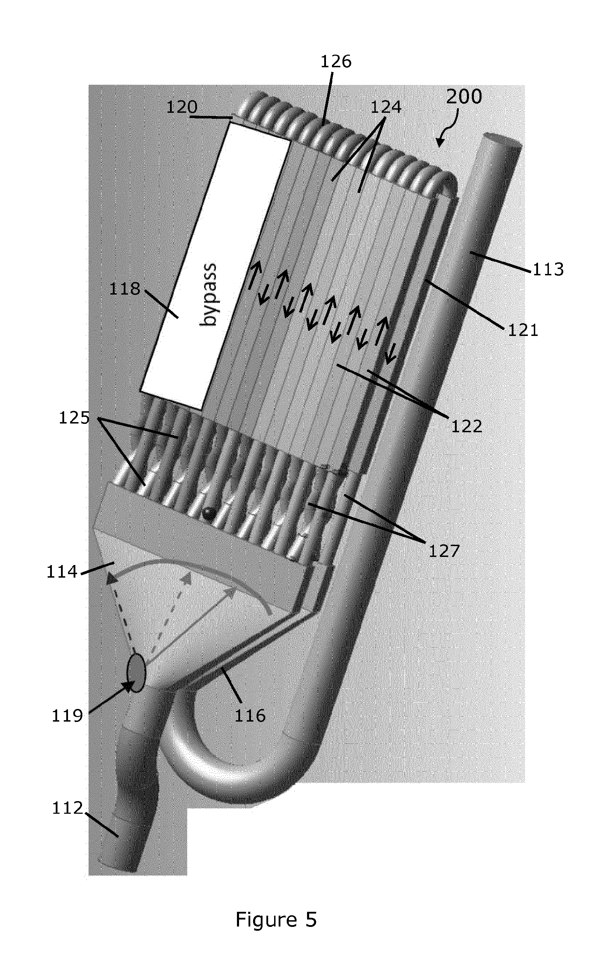

Figure 5 shows a further embodiment of a heat recovery system 200 according to the present invention. The arrangement of the inlet and outlet diffusers 114, 116, heat exchangers 120, 121 and connecting pipes 125, 126, 127 is the same as in heat recovery system 100 shown in Figure 3.

However, in Figure 5 there is no separate bypass channel. Rather, the bypass channel 118 comprises five pairs of heat exchange conduits (i.e. five adjacent conduits of the upper and lower heat exchangers 120, 121). In use, no thermoelectric generators will be in thermal contact with the heat exchange conduits forming the bypass channel 118.

In Figure 5, the bypass channel 118 is formed at the top edge of the heat exchangers 120, 121; however, in other examples the bypass channel 118 may be positioned differently. The conduits forming the bypass channel 118 do not comprise any thermally conductive fins, thus the bypass channel 118 may have a lower resistance than the remaining heat exchange conduits 122, 124, which heat exchange conduits 122, 124 may comprise thermally conductive fins in some embodiments.

The conduit wall which separates the bypass channel 118 from the heat exchange conduits 122, 124 may be thermally insulated. This may prevent or reduce heat exchange between the bypass channel 118 and the thermoelectric generators (not shown) when the bypass channel 118 is activated.

A control valve 119 is located in the inlet diffuser 114. The control valve 119 is operable to regulate the flow rate through each of the heat exchange conduits 122, 124 (e.g. by adjusting the amount of fluid supplied to each first heat exchange conduit 122). This may increase the power output of the system 200 while still minimising or even cancelling the gradient in the temperature of the surfaces of the thermoelectric generators that are in thermal contact with the heat exchange conduits of the heat exchangers 120, 121.

For example, if the temperature and/or pressure of the fluid in certain heat exchange conduits 122, 124 is too high, the control valve 119 can reduce the flow rate to those conduits and redirect fluid to heat exchange conduits which have a lower temperature and/or pressure. This may prevent, in use, premature activation of the bypass channel 118 by delaying any of the thermoelectric generators from reaching a critical condition.

The control valve 119 is operable to activate the bypass channel 118 by directing the inlet fluid towards the designated conduits forming the bypass channel 118. After passing through the bypass channel 118 the fluid passes through the outlet diffuser 116 and the outlet 113, the same as when the bypass is not activated.

Thus, unlike the system in Figure 3, the bypass channel 118 in Figure 5 may not be a 'perfect' bypass, as some fluid may still flow through the heat exchange conduits 122, 124 when the bypass channel 118 is activated.

Optionally, the system in Figure 3 may comprise a control valve 119 to regulate flow rate in addition to the separate bypass channel 18 and valve 19 operable to activate the bypass channel 18.

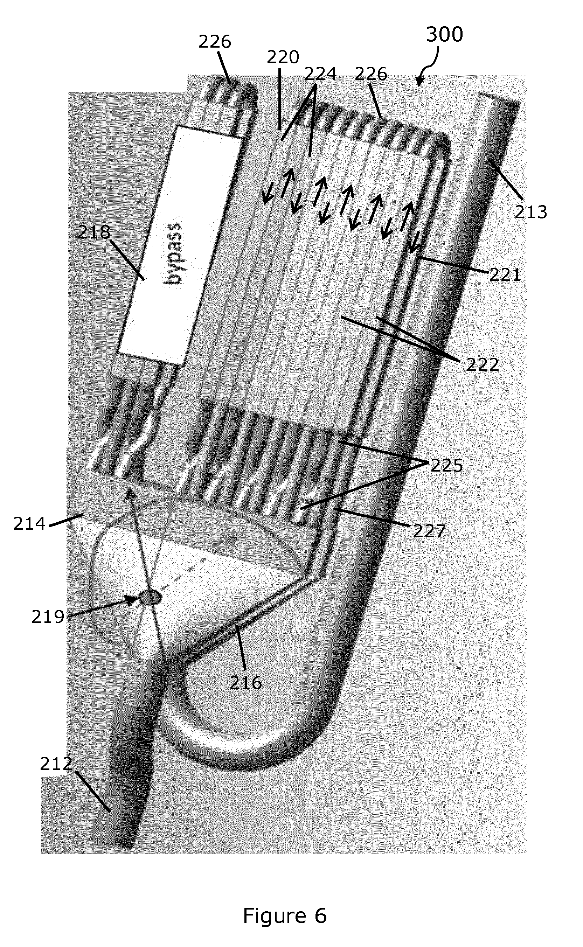

Another example of a heat recovery system 300 is shown in Figure 6. The features of system 300 are the same as system 200 shown in Figure 5, except for the bypass channel and the control valve.

In Figure 6, the control valve 219 is located further down the body of the inlet diffuser 214. The heat exchange conduits forming the bypass channel 218 are separated from (i.e. not in contact with) the remaining heat exchange conduits of the upper 220 or lower 221 heat exchangers. This air gap at least partially thermally insulates the bypass channel 218 from the thermoelectric generator(s) in contact with the heat exchange conduits 222, 224.

In Figure 6 the bypass channel 218 has been isolated by removing three of the heat exchange conduits adjacent the bypass channel 218. Thus, the bypass channel 218 is only formed of three pairs of conduits 222, 224 rather than five pairs as in Figure 5. However, in other examples the bypass channel 218 may comprise more or less than three pairs of conduits.

The positioning of the control valve 219 and the bypass channel 218 in Figure 6 provides a 'perfect' bypass, as when the control valve 219 activates the bypass channel 218 fluid cannot flow through the remaining heat exchange conduits 222, 224. The control valve 219 can also still regulate the flow rate to each of the heat exchange conduits 222, 224.

As in Figure 5, the bypass channel 218 in Figure 6 is not in thermal contact with any thermoelectric generators. Also, the heat exchange conduits forming the bypass channel 218 may not comprise any thermally conductive fins.

A possible drawback of the system 300 is that there is a reduced space to place thermoelectric generators on the heat exchangers 220, 221 (as there are fewer conduits available). This may be counteracted by providing one or more additional heat exchangers (i.e. increasing the levels of heat exchangers to three of more), or increasing the number of heat exchange conduits per heat exchanger.

The above embodiments are described by way of example only. Many variations are possible without departing from the scope of the invention.

## Claims

1. A thermoelectric heat recovery system comprising:
an inlet for receiving a fluid;
an outlet;
a heat exchanger located between, and in fluid communication with, the inlet and the outlet, the heat exchanger comprising a plurality of heat exchange conduits, wherein, in use, the fluid flows in a first direction through a given heat exchange conduit and in a second direction opposite to the first direction through the or each heat exchange conduit adjacent the given heat exchange conduit; and
one or more thermoelectric generators, wherein the or each thermoelectric generator has a heat exchanger contact surface which is in thermal contact with at least a portion of at least two adjacent heat exchange conduits, such that, in use, the heat exchanger contact surface forms the hot side or cold side of the thermoelectric generator.

2. The system of claim 1, wherein each heat exchange conduit comprises a first end and a second end, wherein, in use, fluid flows from the first end of each heat exchange conduit to the second end of each heat exchange conduit.

3. The system of claim 2, wherein the first end of each heat exchange conduit is in fluid communication with the inlet and/or wherein the second end of each heat exchange conduit is in fluid communication with the outlet.

4. The system of claim 2, wherein the heat exchanger comprises a plurality of first heat exchange conduits and a plurality of second heat exchange conduits, the direction of fluid flow, in use, through the first heat exchange conduits being opposite that through the second heat exchange conduits, wherein each first heat exchange conduit is positioned adjacent to at least one second heat exchange conduit such that the first end of each first heat exchange conduit is adjacent to the second of a second heat exchange conduit.

5. The system of any of claims 1 to 4, further comprising at least two heat exchangers, optionally or preferably wherein the two or more heat exchangers are stacked into layers.

6. The system of claim 5 as it depends on claim 4, comprising at least one upper heat exchanger and at least one lower heat exchanger, wherein each first heat exchange conduit in the upper heat exchanger(s) is in fluid communication with a second heat exchange conduit in a lower heat exchanger, and each second heat exchange conduit in the upper heat exchanger(s) is in fluid communication with a first heat exchange conduit in a lower heat exchanger.

7. The system of any of claims 1 to 6, further comprising a plurality of connecting pipes to connect the heat exchanger(s) in fluid communication with the inlet and/or the outlet, optionally or preferably, wherein the plurality of connecting pipes are thermally insulating and/or are substantially surrounded by thermal insulation.

8. The system of claim 7 as it depends on claim 4 or claim 6, wherein the second end of each first heat exchange conduit is connected to the first end of one of the plurality of second heat exchange conduits by one of the plurality of connecting pipes.

9. The system of claim 7 or claim 8, further comprising:
an inlet diffuser connected to the inlet, wherein the inlet diffuser comprises a plurality of apertures, each aperture configured to receive at least one of the plurality of connecting pipes; and/or
an outlet diffuser connected to the outlet, wherein the outlet diffuser comprises a plurality of apertures, each aperture configured to receive at least one of the plurality of connecting pipes.

10. The system of claim 9 as it depends on claim 8, wherein:
the first end of each first heat exchange conduit is connected to the inlet diffuser by one of the plurality of connecting pipes; and/or.
the second end of each second heat exchange conduit is connected to the outlet diffuser by one of the plurality of connecting pipes.

11. The system of any of claims 1 to 10, further comprising at least one bypass channel in fluid communication with the inlet, wherein the at least one bypass channel is configured to bypass one or more of the thermoelectric generators.

12. The system of claim 11, wherein:
the or each heat exchanger comprises at least one heat exchange conduit not in thermal contact with any of the one or more thermoelectric generators and wherein the at least one heat exchange conduit forms the bypass channel(s); and/or.
the system further comprises a valve operable, in use, to activate the bypass channel(s) when the temperature and/or pressure of the fluid exceeds a predetermined threshold, optionally or preferably wherein the valve is located within the inlet diffuser and/or wherein the valve is operable to regulate the flow rate through each of the heat exchange conduits.

13. A method of converting waste heat into electricity, the method comprising:
providing a heat recovery system according to the any of claims 1 to 12;
providing a waste hot fluid or a waste cold fluid;
channelling said waste hot fluid or said waste cold fluid through the heat exchange conduits of the heat exchanger(s) of the heat recovery system
generating electricity using the thermoelectric generator(s) of the heat recover system.

14. An exhaust system comprising the heat recovery system of any of claims 1 to 12, wherein the fluid is an exhaust fluid and the heat exchange contact surface(s) of form the hot side of the thermoelectric generator(s).

15. A structure such as a building or a vehicle comprising or having coupled thereto at least one heat recovery system according to any of claims 1 to 12.
